# EUROPEAN PATENT APPLICATION

(11) **EP 4 056 727 A1**
(43) Date of publication of application: **14.09.2022**
(21) Application number: 22161313.6
(22) Date of filing: 10.03.2022
(51) Int. Cl.: C23C 14/06, B22D 17/22, B22D 21/00, C23C 28/00, B22C 3/00

(54) **PVD COATINGS FOR ALUMINUM DIE CASTING MOLDS**

(30) Priority: 10.03.2021 US 202163159216 P
(71) Applicant: Vapor Technologies, Inc., Longmont CO 80503 (US)
(72) Inventor: ANTON, Bryce Randolph, Longmont, 80503 (US); KUNRATH, Augusto, Denver, 80220 (US)
(74) Representative: Beck Greener LLP

(57) **Abstract**

A die-cast mold for die casting aluminum includes a first die having a first mold surface, a first multilayer coating disposed over the first mold surface, a second die having a second mold surface, and a second multilayer coating disposed over the second mold surface. The first multilayer coating includes a first base layer and the second multilayer coating includes a second base layer. The first die and the second die mate to form a mold cavity. Characteristically, the first base layer and the second base layer are each independently composed of a zirconium nitride or a zirconium carbide.

## Description

### TECHNICAL FIELD

In at least one aspect, release coatings aluminum die casting molds based on zirconium are provided.

### BACKGROUND

Die casting is a casting process in which molten metal is introduced into a mold cavity under pressure. Examples of metals that can be used in the die-casting process include aluminum, aluminum alloys, zinc, lead, pewter, and tin alloys. The mold cavity is formed by the mating together of at least two hardened steel dies that are machined to conform to the shape of the part to be formed. The surfaces of the mold cavity are typically coated with a release layer in order to prevent sticking of the formed part to the molding surface and spoilage of the formed part. Therefore, it is desirable that such release layers be chemically inert.

Accordingly, there is a need for new release layers that are economical and easily coated onto the molding surface.

### SUMMARY

In at least one aspect, a die-cast mold for die casting aluminum or another metal or metal alloy is provided. The die-cast mold includes a first die having a first mold surface and a second die having a second mold surface. A first multilayer coating is disposed over the first mold surface and a second multilayer coating is disposed over the second mold surface. The first multilayer coating includes a first base layer and the second multilayer coating includes a second base layer. Characteristically, the first die and the second die mate to form a mold cavity. Advantageously, the first base layer and the second base layer are each independently composed of a zirconium nitride or a zirconium carbide.

In another aspect, a die-cast mold for die casting aluminum or another metal or metal alloy is provided. The die-cast mold includes a first die having a first mold surface and a second die having a second mold surface. A first multilayer coating is disposed over the first mold surface and a second multilayer coating is disposed over the second mold surface. The first multilayer coating includes a first base layer and a first zirconium oxide layer disposed over the first base layer. Similarly, the second multilayer coating includes a second base layer and a second zirconium oxide layer disposed over the second base layer. Characteristically, the first die and the second die mate to form a mold cavity. Advantageously, the first base layer and the second base layer are each independently composed of a zirconium nitride or a zirconium carbide.

The foregoing summary is illustrative only and is not intended to be in any way limiting. In addition to the illustrative aspects, embodiments, and features described above, further aspects, embodiments, and features will become apparent by reference to the drawings and the following detailed description.

### BRIEF DESCRIPTION OF THE DRAWINGS

For a further understanding of the nature, objects, and advantages of the present disclosure, reference should be had to the following detailed description, read in conjunction with the following drawings, wherein like reference numerals denote like elements and wherein:
FIGURE 1A. Schematic cross-section of an opened die mold having surfaces coated with a zirconium-based layer.
FIGURE IB. Schematic cross-section of a closed die mold having surfaces coated with a zirconium-based layer with molten aluminum enclosed in the mold cavity.
FIGURE 2 provides a schematic cross-section of a multilayer coating disposed over a die surface.
FIGURE 3 provides a schematic cross-section of a multilayer coating disposed over a die surface having a top zirconium oxide layer.

### DETAILED DESCRIPTION

Reference will now be made in detail to presently preferred compositions, embodiments and methods of the present invention, which constitute the best modes of practicing the invention presently known to the inventors. The Figures are not necessarily to scale. However, it is to be understood that the disclosed embodiments are merely exemplary of the invention that may be embodied in various and alternative forms. Therefore, specific details disclosed herein are not to be interpreted as limiting, but merely as a representative basis for any aspect of the invention and/or as a representative basis for teaching one skilled in the art to variously employ the present invention.

Except in the examples, or where otherwise expressly indicated, all numerical quantities in this description indicating amounts of material or conditions of reaction and/or use are to be understood as modified by the word "about" in describing the broadest scope of the invention. Practice within the numerical limits stated is generally preferred. Also, unless expressly stated to the contrary: percent, "parts of," and ratio values are by weight; the term "polymer" includes "oligomer," "copolymer," "terpolymer," and the like; molecular weights provided for any polymers refers to weight average molecular weight unless otherwise indicated; the description of a group or class of materials as suitable or preferred for a given purpose in connection with the invention implies that mixtures of any two or more of the members of the group or class are equally suitable or preferred; description of constituents in chemical terms refers to the constituents at the time of addition to any combination specified in the description, and does not necessarily preclude chemical interactions among the constituents of a mixture once mixed; the first definition of an acronym or other abbreviation applies to all subsequent uses herein of the same abbreviation and applies mutatis mutandis to normal grammatical variations of the initially defined abbreviation; and, unless expressly stated to the contrary, measurement of a property is determined by the same technique as previously or later referenced for the same property.

It must also be noted that, as used in the specification and the appended claims, the singular form "a," "an," and "the" comprise plural referents unless the context clearly indicates otherwise. For example, reference to a component in the singular is intended to comprise a plurality of components.

As used herein, the term "about" means that the amount or value in question may be the specific value designated or some other value in its neighborhood. Generally, the term "about" denoting a certain value is intended to denote a range within +/- 5% of the value. As one example, the phrase "about 100" denotes a range of 100+/- 5, i.e. the range from 95 to 105. Generally, when the term "about" is used, it can be expected that similar results or effects according to the invention can be obtained within a range of +/- 5% of the indicated value.

As used herein, the term "and/or" means that either all or only one of the elements of said group may be present. For example, "A and/or B" shall mean "only A, or only B, or both A and B". In the case of "only A", the term also covers the possibility that B is absent, i.e. "only A, but not B".

It is also to be understood that this invention is not limited to the specific embodiments and methods described below, as specific components and/or conditions may, of course, vary. Furthermore, the terminology used herein is used only for the purpose of describing particular embodiments of the present invention and is not intended to be limiting in any way.

The term "comprising" is synonymous with "including," "having," "containing," or "characterized by." These terms are inclusive and open-ended and do not exclude additional, unrecited elements or method steps.

The phrase "consisting of' excludes any element, step, or ingredient not specified in the claim. When this phrase appears in a clause of the body of a claim, rather than immediately following the preamble, it limits only the element set forth in that clause; other elements are not excluded from the claim as a whole.

The phrase "consisting essentially of' limits the scope of a claim to the specified materials or steps, plus those that do not materially affect the basic and novel characteristic(s) of the claimed subject matter.

The phrase "composed of' means "including" or "consisting of." Typically, this phrase is used to denote that an object is formed from a material.

With respect to the terms "comprising," "consisting of," and "consisting essentially of," where one of these three terms is used herein, the presently disclosed and claimed subject matter can include the use of either of the other two terms.

The term "one or more" means "at least one" and the term "at least one" means "one or more." The term "one or more" means "at least one" and the term "at least one" means "one or more." The terms "one or more" and "at least one" include "plurality" and "multiple" as a subset. In a refinement, "one or more" includes "two or more."

The term "substantially," "generally," or "about" may be used herein to describe disclosed or claimed embodiments. The term "substantially" may modify a value or relative characteristic disclosed or claimed in the present disclosure. In such instances, "substantially" may signify that the value or relative characteristic it modifies is within ± 0%, 0.1%, 0.5%, 1%, 2%, 3%, 4%, 5% or 10% of the value or relative characteristic.

It should also be appreciated that integer ranges explicitly include all intervening integers. For example, the integer range 1-10 explicitly includes 1, 2, 3, 4, 5, 6, 7, 8, 9, and 10. Similarly, the range 1 to 100 includes 1, 2, 3, 4.... 97, 98, 99, 100. Similarly, when any range is called for, intervening numbers that are increments of the difference between the upper limit and the lower limit divided by 10 can be taken as alternative upper or lower limits. For example, if the range is 1.1. to 2.1 the following numbers 1.2, 1.3, 1.4, 1.5, 1.6, 1.7, 1.8, 1.9, and 2.0 can be selected as lower or upper limits.

When referring to a numeral quantity, in a refinement, the term "less than" includes a lower non-included limit that is 5 percent of the number indicated after "less than." For example, "less than 20" includes a lower non-included limit of 1 in a refinement. Therefore, this refinement of "less than 20" includes a range between 1 and 20. In another refinement, the term "less than" includes a lower non-included limit that is, in increasing order of preference, 20 percent, 10 percent, 5 percent, or 1 percent of the number indicated after "less than."

In the examples set forth herein, concentrations, temperature, and reaction conditions (e.g., pressure, pH, flow rates, etc.) can be practiced with plus or minus 50 percent of the values indicated rounded to or truncated to two significant figures of the value provided in the examples. In a refinement, concentrations, temperature, and reaction conditions (e.g., pressure, pH, flow rates, etc.) can be practiced with plus or minus 30 percent of the values indicated rounded to or truncated to two significant figures of the value provided in the examples. In another refinement, concentrations, temperature, and reaction conditions (e.g., pressure, pH, flow rates, etc.) can be practiced with plus or minus 10 percent of the values indicated rounded to or truncated to two significant figures of the value provided in the examples.

For all compounds expressed as an empirical chemical formula with a plurality of letters and numeric subscripts (e.g., CH₂O), values of the subscripts can be plus or minus 50 percent of the values indicated rounded to or truncated to two significant figures. For example, if CH₂O is indicated, a compound of formula C_{(0.8-1.2})H(_{1.6-2.4})O(_{0.8-1.2}). In a refinement, values of the subscripts can be plus or minus 30 percent of the values indicated rounded to or truncated to two significant figures. In still another refinement, values of the subscripts can be plus or minus 20 percent of the values indicated rounded to or truncated to two significant figures.

Throughout this application, where publications are referenced, the disclosures of these publications in their entireties are hereby incorporated by reference into this application to more fully describe the state of the art to which this invention pertains.

### Abbreviations:

"PVD" means physical vapor deposition.

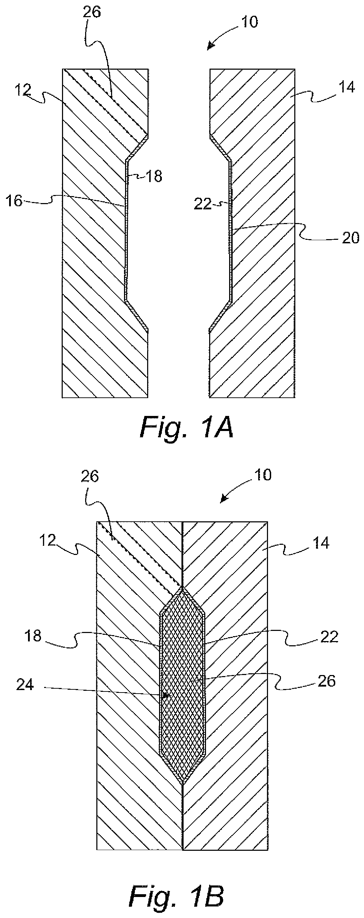

With reference to Figures 1A and 1B, schematics of a die-cast mold for die casting aluminum or another metal or metal alloy is provided. Figure 1A is a schematic cross-section of when the mold halves are separated, while Figure 1B is a schematic cross-section when the mold is closed and filled with liquid aluminum. Die-cast mold 10 includes first die 12 and second die 14. First die 12 defines a first mold surface 16, First coating 18 is disposed over the first mold surface 16. Second die 14 defines a second mold surface 20. Second multilayer coating 22 is disposed over the second mold surface 20. Characteristically, first die 12 and second die 14 are mateable to form a mold cavity 24. Characteristically, first multilayer coating 18 and second multilayer coating 22 each independently include a base layer composed of a zirconium nitride or a zirconium carbide

Referring to Figure 1B, a molten metal 24 can be introduced into mold cavity 22 via input channel 26. First multilayer coating 18 and second multilayer coating 22 operate as a release layer and protective layer for the mold surface. Thermodynamically, first multilayer coating 18 and second multilayer coating 22 tend to form oxides preferentially as compared to the molten metal introduced into the mold cavity due to the fact that the multilayer coatings include at least one zirconium-based layer.

In a variation, first multilayer coating 18 and second multilayer coating 22 are each formed by physical vapor deposition. Examples of suitable physical vapor deposition methods include, but are not limited to, cathodic arc deposition, sputtering, evaporation, and the like. Therefore, the first multilayer coating and the second multilayer coating are substantially pinhole free. In a refinement, first multilayer coating 18 and second multilayer coating 22 each independently have a pinhole density less than about 50 pinholes/mm². In some refinements, first multilayer coating 18 and second multilayer coating 22 each independently have a pinhole density less than, in increasing order of preference, 100 pinholes/mm², 70 pinholes/mm², 60 pinholes/mm², 50 pinholes/mm², 40 pinholes/mm², 40 pinholes/mm², 30 pinholes/mm², 20 pinholes/mm², 10 pinholes/mm², or 5 pinholes/mm². In some refinements, the first multilayer coating 18 and second multilayer coating 22 as formed are smooth, having a surface roughness that is less than 60 nm. In other refinements, the first multilayer coating 18 and second multilayer coating 22 each independently have a surface roughness less than in increasing order of preference, 100 nm, 70 nm, 60 nm, 50 nm, 40 nm, 30 nm, 20 nm, or 10 nm.

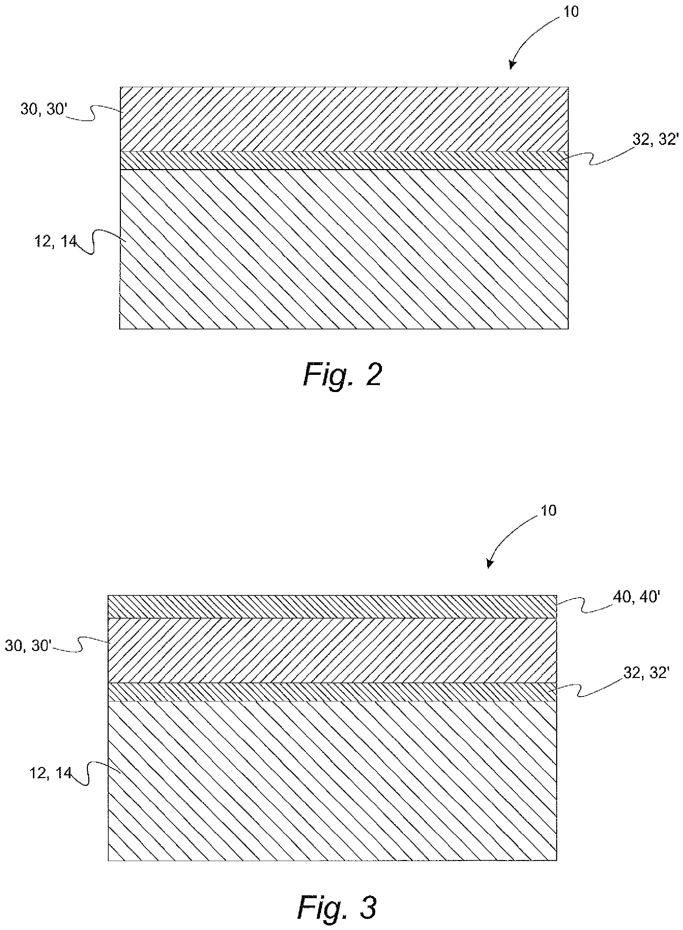

Figures 2 and 3 provide schematic cross-sections of a multilayer coating that can be used for first multilayer coating 18 and second multilayer coating. First base layer 30 is disposed over surface 16 of die 12 and second base layer 30' is disposed over surface 20 of dies14 at least in the areas that define the mold cavity. In a refinement, first base layer 30 and second base layer 30' each independently have a thickness from about 1 micron to 5 microns. In some refinement, first base layer 30 and second base layer 30' each independently have a thickness of at least, in increasing order of preference, 0.5 microns, 1 micron, 1.2 microns, 1.5 microns, 1.7 microns, or 2 microns, and at most, in increasing order of preference, 7 microns, 5 microns, 4 microns, 3.5 microns, 3 microns, 2.8 microns, or 2.5 microns.

As set forth above, first base layer 30 and second base layer 30' are each independently composed of a zirconium nitride or a zirconium carbide. In a refinement, the base layers are independently composed of a component selected from the group consisting of zirconium nitride (ZrN), zirconium carbonitride (ZrCN), zirconium oxycarbide (ZrOC), zirconium aluminum nitride (ZrAIN), and zirconium silicon carbonitride (ZrSiCN).

In a refinement, first adhesion layer 32 is disposed between first base layer 30 and die 12 while second adhesion layer 32' is disposed between second base layer 30' and die 14. First adhesion layer 32 and second adhesion layer 32' each independently have a thickness from about 0.05 microns to about 0.5 microns. Typically, first adhesion layer 32 and second adhesion layer 32' are each independently composed of a metal. In a refinement, first adhesion layer 32 and second adhesion layer 32' are each independently composed of titanium or zirconium.

Figure 3 depicts a variation, in which first zirconium oxide layer 40 is disposed over and contacting the first base layer 30 and second first zirconium oxide layer 40' is disposed over and contacting the second base layer 30'. Typically, first zirconium oxide layer 40 and second zirconium oxide layer 40' each independently has a thickness of about 0.1 to 1 micron. In a variation, first zirconium oxide layer 40 and second zirconium oxide layer 40' each independently has a surface roughness that is less than 60 nm. In other refinements, the first zirconium oxide layer 40 and second zirconium oxide layer 40' each independently have a surface roughness less than in increasing order of preference, 100 nm, 70 nm, 60nm, 50 nm, 40 nm, 30 nm, 20 nm, or 10 nm.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

There is disclosed a die-cast mold comprising: a first die having a first mold surface; a first multilayer coating disposed over the first mold surface, the first multilayer coating including a first base layer; a second die having a second mold surface; and a second multilayer coating disposed over the second mold surface, the second multilayer coating including a second base layer, the first die and the second die mating to define a mold cavity, wherein the first base layer and the second base layer are each independently composed of a zirconium nitride or a zirconium carbide.

In an embodiment, the first multilayer coating and the second multilayer coating are each formed by physical vapor deposition.

In an embodiment, the first multilayer coating and the second multilayer coating are substantially pinhole free.

In an embodiment, the first multilayer coating and the second multilayer coating each independently have a pinhole density less than about 50 pinholes/mm².

In an embodiment, the first multilayer coating and the second multilayer coating each independently have a surface roughness that is less than 60 nm.

In an embodiment, the first base layer and the second base layer are each independently composed of a component selected from the group consisting of zirconium nitride (ZrN), zirconium carbonitride (ZrCN), zirconium oxycarbide (ZrOC), zirconium aluminum nitride (ZrAIN), and zirconium silicon carbonitride (ZrSiCN).

In an embodiment, the first base layer and the second base layer each independently have a thickness from about 1 micron to 5 microns.

In an embodiment, the first multilayer coating further includes a first adhesion layer interposed between and contacting the first mold surface and the first base layer and a second adhesion layer interposed between and contacting the second mold surface and the second base layer.

In an embodiment, the first adhesion layer and the second adhesion layer are each independently composed of a metal.

In an embodiment, the first adhesion layer and the second adhesion layer are each composed of titanium or zirconium.

In an embodiment, the first adhesion layer and the second adhesion layer each independently have a thickness from about 0.05 microns to about 0.5 microns.

In an embodiment, the first multilayer coating further includes a first zirconium oxide layer disposed over and contacting the first base layer and a second zirconium oxide layer disposed over and contacting the second base layer.

In an embodiment, the first zirconium oxide layer and the second zirconium oxide layer each independently having a thickness from about 0.1 to 1 micron.

There is also disclosed a die-cast mold comprising: a first die having a first mold surface; a first multilayer coating disposed over the first mold surface, the first multilayer coating including a first base layer and a first zirconium oxide layer disposed over the first base a second die having a second mold surface; and a second multilayer coating disposed over the second mold surface, the second multilayer coating including a second base layer and a second zirconium oxide layer disposed over the second base layer, the first die and the second die mating to define a mold cavity, wherein the first base layer and the second base layer are each independently composed of a zirconium nitride or a zirconium carbide.

In an embodiment, the first multilayer coating and the second multilayer coating are each formed by physical vapor deposition.

In an embodiment, the first multilayer coating and the second multilayer coating are each formed by cathodic arc deposition, sputtering, or evaporation.

In an embodiment, the first zirconium oxide layer and the second zirconium oxide layer each independently have a surface roughness that is less than 60 nm.

In an embodiment, the first base layer and the second base layer are each independently composed of a component selected from the group consisting of zirconium nitride (ZrN), zirconium carbonitride (ZrCN), zirconium oxycarbide (ZrOC), zirconium aluminum nitride (ZrAIN), and zirconium silicon carbonitride (ZrSiCN).

In an embodiment, the die-cast mold further comprises a first adhesion layer interposed between and contacting the first mold surface and the first base layer and a second adhesion layer interposed between and contacting the second mold surface and the second base layer.

In an embodiment, the first zirconium oxide layer and the second zirconium oxide layer each independently having a thickness from about 0.1 to 1 micron and wherein the first base layer and the second base layer each independently have a thickness from about 1 microns to 5 microns.

## Claims

1. A die-cast mold comprising:
a first die having a first mold surface;
a first multilayer coating disposed over the first mold surface, the first multilayer coating including a first base layer;
a second die having a second mold surface; and
a second multilayer coating disposed over the second mold surface, the second multilayer coating including a second base layer, the first die and the second die mating to define a mold cavity, wherein the first base layer and the second base layer are each independently composed of a zirconium nitride or a zirconium carbide.

2. The die-cast mold of claim 1 wherein the first multilayer coating and the second multilayer coating are each formed by physical vapor deposition.

3. The die-cast mold of claim 1 or 2, wherein the first multilayer coating and the second multilayer coating are substantially pinhole free.

4. The die-cast mold of any of claims 1 to 3, wherein the first multilayer coating and the second multilayer coating each independently have a pinhole density less than about 50 pinholes/mm².

5. The die-cast mold of any of claims 1 to 4, wherein the first multilayer coating and the second multilayer coating each independently have a surface roughness that is less than 60 nm.

6. The die-cast mold of any of claims 1 to 5, wherein the first base layer and the second base layer are each independently composed of a component selected from the group consisting of zirconium nitride (ZrN), zirconium carbonitride (ZrCN), zirconium oxycarbide (ZrOC), zirconium aluminum nitride (ZrAIN), and zirconium silicon carbonitride (ZrSiCN).

7. The die-cast mold of any of claims 1 to 6, wherein the first base layer and the second base layer each independently have a thickness from about 1 micron to 5 microns.

8. The die-cast mold of any of claims 1 to 7, wherein the first multilayer coating further includes a first adhesion layer interposed between and contacting the first mold surface and the first base layer and a second adhesion layer interposed between and contacting the second mold surface and the second base layer.

9. The die-cast mold of claim 8, wherein the first adhesion layer and the second adhesion layer are each independently composed of a metal.

10. The die-cast mold of claim 8 or 9, wherein the first adhesion layer and the second adhesion layer are each composed of titanium or zirconium.

11. The die-cast mold of any of claims 8 to 10, wherein the first adhesion layer and the second adhesion layer each independently have a thickness from about 0.05 microns to about 0.5 microns.

12. The die-cast mold of any of claims 1 to 11, wherein the first multilayer coating further includes a first zirconium oxide layer disposed over and contacting the first base layer and a second zirconium oxide layer disposed over and contacting the second base layer.

13. The die-cast mold of claim 12 wherein the first zirconium oxide layer and the second zirconium oxide layer each independently having a thickness from about 0.1 to 1 micron.

14. The die-cast mold of claim 1, wherein the first multilayer coating and the second multilayer coating are each formed by physical vapor deposition.

15. The die-cast mold of claim 1, wherein the first multilayer coating and the second multilayer coating are each formed by cathodic arc deposition, sputtering, or evaporation and optionally wherein the first zirconium oxide layer and the second zirconium oxide layer each independently have a surface roughness that is less than 60 nm.
